# EUROPEAN PATENT SPECIFICATION

(11) **EP 1 808 727 B1**
(45) Date of publication and mention of the grant of the patent: **30.05.2012**
(21) Application number: 06100319.0
(22) Date of filing: 13.01.2006
(51) Int. Cl.: G02F 1/1362, H01L 27/02

(54) **Display device for displayed images involving display pixels and non-display pixels**
Anzeigevorrichtung für angezeigte Bilder mit Anzeigepixeln und Nichtanzeigepixeln
Dispositif d'affichage pour des images affichées utilisant des pixels affichables et des pixels non-affichables

(43) Date of publication of application: 18.07.2007
(73) Proprietor: Chimei InnoLux Corporation, Chu-Nan 350 Miao li 350 (TW)
(72) Inventor: Lin, Ching-Wei, 330, Taoyuan City, Taoyuan County, R.O.C (TW); Huang, Jing-Chen, Tainan City, R.O.C. (TW)
(74) Representative: 2K Patentanwälte Blasberg Kewitz & Reichel

(56) References cited:
- US-A- 5 373 377
- US-A- 5 767 928
- US-A1- 2003 210 359
- US-A1- 2004 264 080

## Description

### BACKGROUND

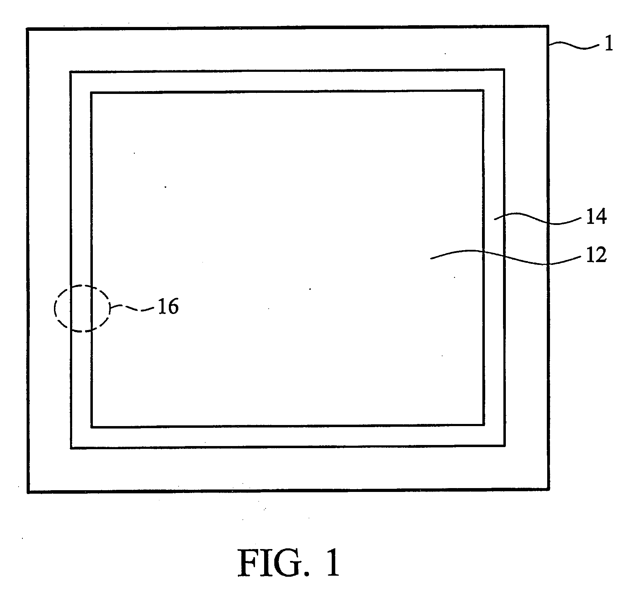

The disclosure relates to image display technologies. Fig. 1 is a schematic diagram of a display panel. The display panel 1 is formed by a deposition step, several photolithography steps, and several etching steps, among others. In any of the aforementioned processing steps, electrostatic charge may accumulate in the display panel. Since electrostatic charge tends to accumulate at the ends of a long metal line, a non-display area 14 is usually required around a display area 12 for reducing the potential of electrostatic discharging damage.

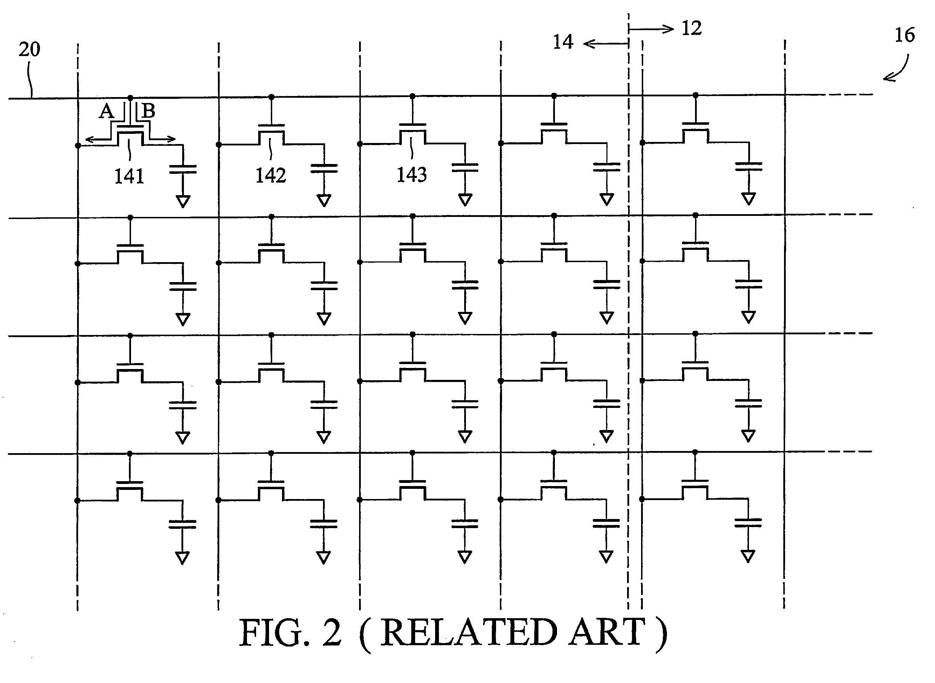

Fig. 2 is a schematic diagram of a portion or block 16 of the display panel 1. Electrostatic charge can be relieved by thin-film transistors (TFTs) in non-display area 14. Taking a long metal line 20 as an example, electrostatic charge is easily accumulated in the end of metal line 20 and then voltage potential decreases from the end to the middle portion of the metal line 20. As such, a dielectric breakdown event will occur in gates of TFTs 141~143 when electrostatic charge accumulated in the left end of metal line 20 reaches a threshold value. Therefore, electrostatic charge can be relieved by the dielectric breakdown event.

Since the dielectric breakdown event is non-recoverable, TFTs 141~143 are easily damaged by electrostatic charge. Electrostatic charge will easily damage TFTs in display area 12 as the accumulated electrostatic charge is larger than that TFTs 141~143 can relieve. Therefore, defects may easily occur in display area 12. Additionally, TFTs 141~143 are incrementally damaged more easily as the amount of electrostatic charge increases during manufacture.

US 2003/0210359 A1 discloses a display device according to the preamble of the respective independent claim of this application. The display comprises a plurality of display pixels and a plurality of non-display pixels, each comprising two dummy thin-film transistors. Therefore, electrostatic charges cannot be discharged efficiently and reliably.

US 5,373,377 discloses an active matrix type LCD device with a short-circuiting wire for mutually short-circuiting address wires and data wires through the medium of resistors. The short-circuiting wire is made of a thin-film transistor (TFT) and is formed along the periphery of a display region on an insulating substrate.

US 5,767,928 discloses a LCD device. A common line is formed on the periphery of a display portion of the LCD. A static electricity preventing device having a first floating gate structure is connected between the gate line and the common line, and a second floating gate structure is connected between the signal line and common line.

### SUMMARY OF INVENTION

It is an object of the invention to provide a display device enabling a more efficient and reliable discharge of electrostatic charges.

The above object is solved by a display device according to claim 1 and 11, respectively. Further advantageous embodiments are the subject-matter of the dependent claims.

### DESCRIPTION OF THE DRAWINGS

The invention can be more fully understood by reading the subsequent detailed description and examples with reference made to the accompanying drawings, wherein:
Fig. 1 is a schematic diagram of a display panel;
Fig. 2 is a schematic diagram of a portion of the display panel of FIG. 1;
Fig. 3 is a schematic diagram of an exemplary embodiment of a display device for displaying images;
Fig. 4a is a schematic diagram of a portion of the display device of FIG. 3;
Fig. 4b is a schematic layout diagram of the embodiment of FIG. 4a;
Fig. 5a is a schematic diagram of another exemplary embodiment of a non-display pixel;
Fig. 5b is a schematic layout diagram of the embodiment of Fig. 5a; and
Fig. 6 is a schematic diagram of another exemplary embodiment of a non-display pixel.

### DETAILED DESCRIPTION

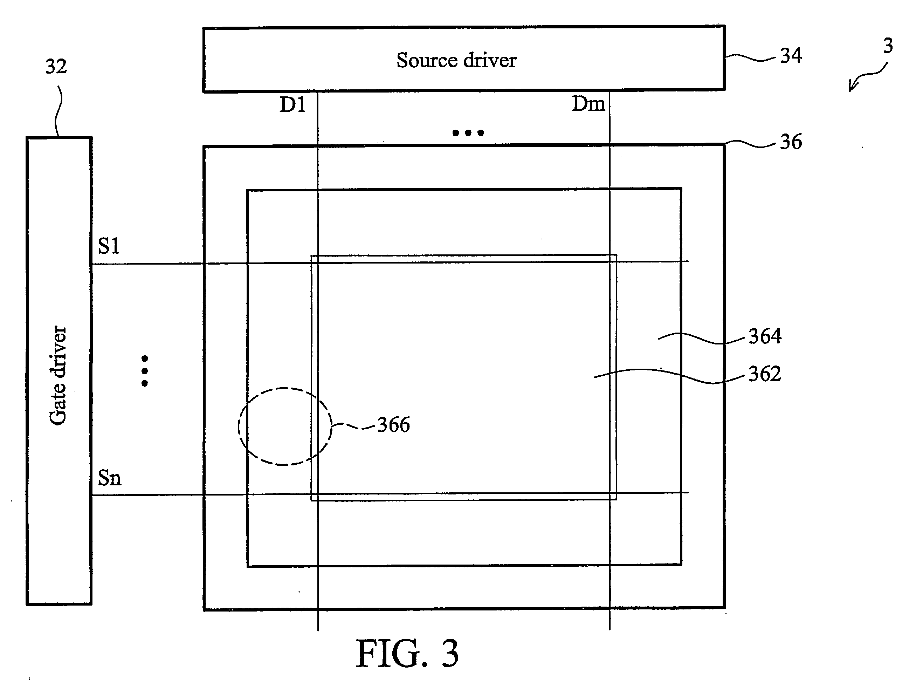

Fig. 3 is a schematic diagram of an exemplary embodiment of a display device for displaying images. In this embodiment, the display device is implemented as an electronic device 3. By way of example, electronic device 3 can be a cellular phone, PDA (personal digital assistant), laptop computer, notebook computer, tablet computer, car TV, or digital camera, etc. Electronic device 3 comprises a gate driver 32, a source driver 34, and a display panel 36. Gate driver 32 supplies scan signals S1~Sn to gate lines. Source driver 34 supplies data signals D1~Dm to source lines. Display panel 36 comprises a display area 362 and a non-display area 364. In some embodiments, a display panel combines a gate driver with a source driver.

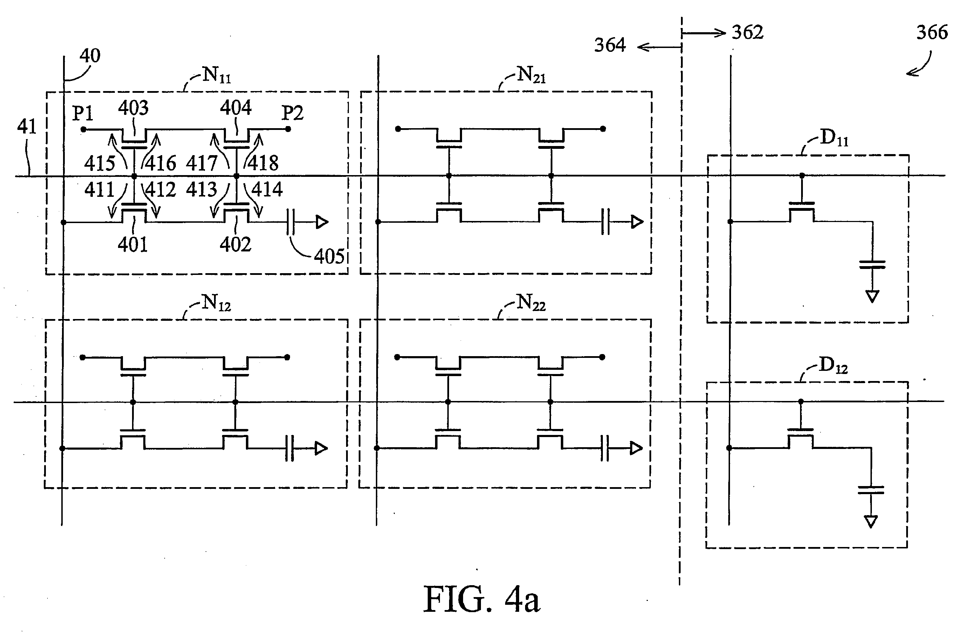

Fig. 4a is a schematic diagram of a portion (block 366) of the display device of FIG. 3. As shown in FIG. 4a, display area 362 comprises display pixels D₁₁~D₁₂. Each display pixel comprises at least one switching TFT. Non-display area 364 comprises non-display pixels N₁₁~N₂₂. Each non-display pixel comprises dummy TFTs. The number of the dummy TFTs of a first non-display pixel among the non-display pixels exceeds the number of the switching TFTs of a first display pixel among the display pixels. The number of the switching TFTs and that of the dummy TFTs are not limited. In this embodiment, each display pixel comprises one switching TFT and each non-display pixel comprises four dummy TFTs.

Display panel 36 can relieve electrostatic charge damage incrementally as the number of the dummy TFTs is increased. Although the number of the dummy TFTs exceeds the number of the switching TFTs, the area of one non-display pixel in non-display area 364 may be equal to the area of one display pixel in display area 362.

Since the structures of non-display pixels N₁₁~N₂₂ are the same, only non-display pixel N₁₁ is described here as an example. As shown in Fig. 4a, non-display pixel N₁₁ comprises dummy TFTs 401~404. Dummy TFT 401 is serially connected to dummy TFT 402 between source line 40 and capacitor 405. Dummy TFT 403 is serially connected to dummy TFT 404 between nodes P 1 and P2. The states of nodes P1 and P2 are floating states.

When electrostatic charge is accumulated in a left end of a metal line 41 and reaches a preset value, a dielectric breakdown event occurs in the gates of dummy TFTs 401~404 such that electrostatic charge is relieved by paths 411~418. Thus, electrostatic charge in the left end of metal line 41 is reduced as electrostatic charge is relieved by non-display pixel N₁₁.

Since the number of the dummy TFTs of non-display pixel N₁₁ is increased, the majority of the electrostatic charge will be relieved by paths 411~418. Therefore, the breakdown event should not occur in the dummy TFTs of non-display pixel N₂₁ and display pixel D₁₁.

When the number of the dummy TFTs of the non-display pixels is increased, the dummy TFTs can relieve more electrostatic charge. Therefore, the capability of relieving ESD of the non-display pixels is increased.

In some embodiments, the channel width or length of one dummy TFT is less than that of one switching TFT for easily triggering the dielectric breakdown event in the dummy TFTs.

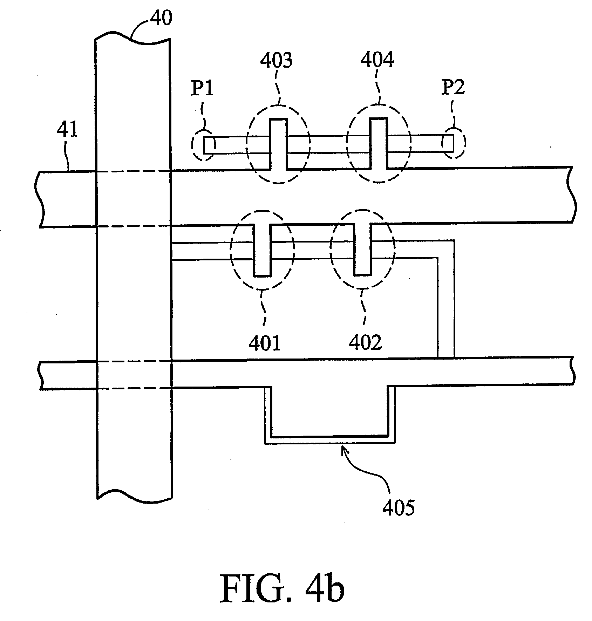

Fig. 4b is a schematic layout diagram of an exemplary embodiment of non-display pixel N₁₁. The gates of dummy TFTs 401~404 are coupled to gate line 41. Dummy TFT 401 is serially connected to dummy TFT 402 between source line 40 and capacitor 405. Dummy TFT 403 is serially connected to dummy TFT 404 between nodes P 1 and P2. Dummy TFT 401 is parallel connected with dummy TFT 403. Dummy TFT 402 is parallel connected with dummy TFT 404.

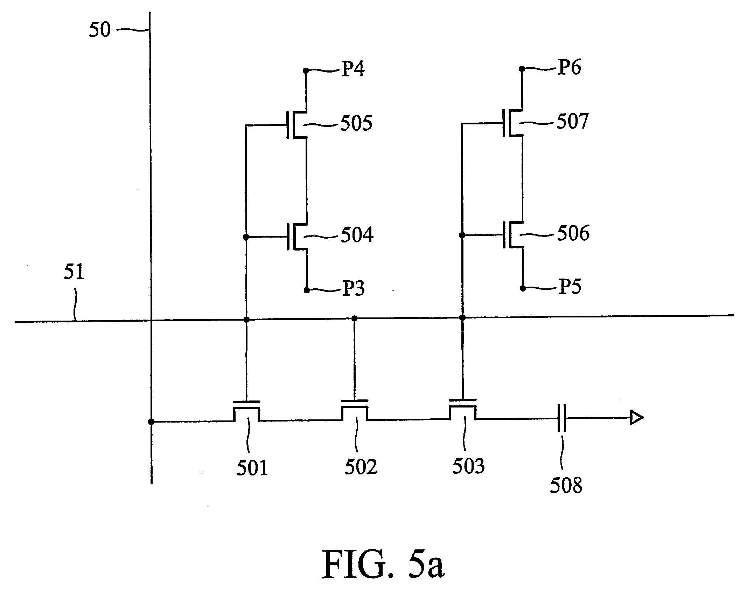

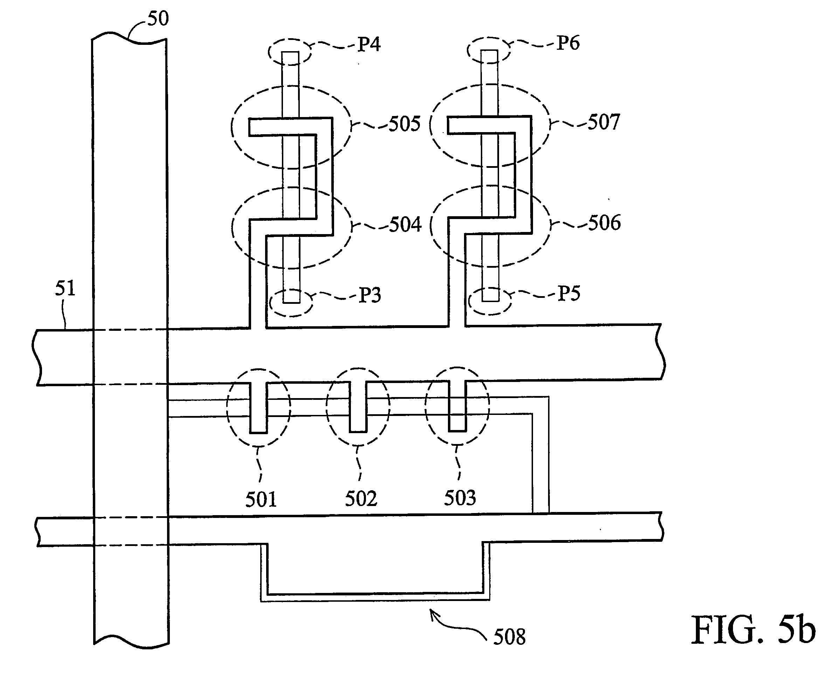

Fig. 5 a is schematic diagram of another exemplary embodiment of the non-display pixel. Fig. 5b is a schematic layout diagram of the embodiment of Fig. 5a. As shown in Figs. 5a and 5b, the gates of dummy TFTs 501~507 are coupled to gate line 51. Dummy TFT 501 is serially connected to dummy TFTs 502 and 503 between source line 50 and capacitor 508. Dummy TFT 504 is serially connected to dummy TFT 505 between nodes P3 and P4. Dummy TFT 506 is serially connected to dummy TFT 507 between nodes P5 and P6. The states of nodes P3∼P6 are floating states. Since Figs. 4a and 5a have the same principle, descriptions of Fig. 5a is omitted.

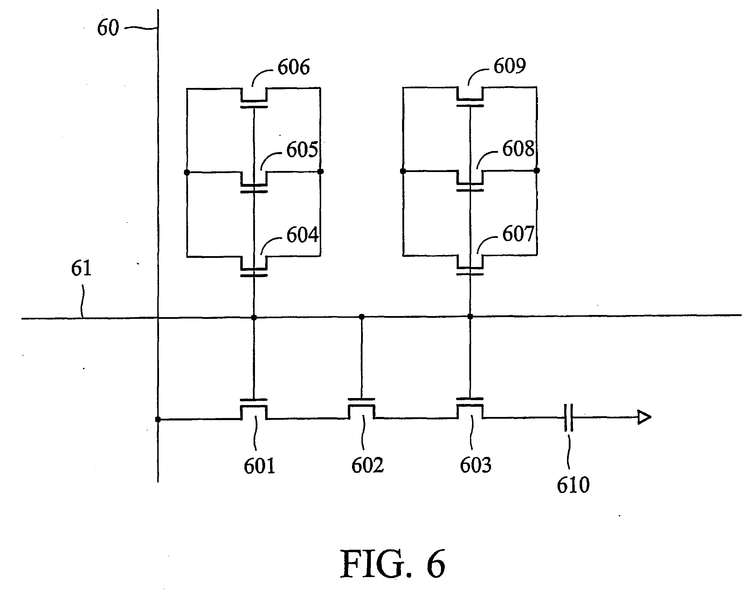

Fig. 6 is a schematic diagram of another exemplary embodiment of a non-display pixel. As shown in FIG. 6, the gates of dummy TFTs 601~609 are coupled to gate line 61. Dummy TFT 601 is serially connected to dummy TFTs 602 and 603 between source line 60 and capacitor 610. Dummy TFT 604 is parallel connected with dummy TFTs 605 and 606. Dummy TFT 607 is parallel connected with dummy TFTs 608 and 609. Dummy TFT 601 is parallel connected with dummy TFT 604. Dummy TFT 603 is parallel connected with dummy TFT 607. Since Figs. 4a and 6 have the same principle, descriptions of Fig. 6 is omitted.

By way of example, different layout methods can be used to provide a number of dummy TFTs of one non-display pixel that exceeds the number of switching TFTs of one display pixel.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A display device for displaying images comprising:
a display panel (36) comprising:
a display area (362) comprising a plurality of display pixels (D11, D12) arranged in a matrix between gate lines (41) and source lines (40), each display pixel comprising at least one switching thin-film transistor; and
a non-display area (364) around the display area (362) comprising plurality of non-display pixels (N11, N12);
each comprising a plurality of dummy thin-film transistors, wherein a number of the dummy thin-film transistors (401-404; 501-507; 601-609) of each non-display pixel (N11) exceeds a number of the switching thin-film transistors of a first display pixel (D11) among the display pixels;
**characterized in that** the dummy thin-film transistors of each non-display pixel (N11) are divided into a first group of a plurality of first dummy thin-film transistors (401, 402) connected in series between a source line and a capacitor (405) and a second group of a plurality of second dummy thin-film transistors (403, 404) connected to each other in series between floating nodes,
wherein all gates of the first group (401, 402) and second group of dummy thin-film transistors (403, 404) are connected to gate lines (41, 51).

2. The display device as claimed in claim 1, wherein the second group of second dummy thin-film transistors comprises a plurality of groups of second dummy thin-film transistors connected to each other in series between floating nodes (504-505, 506-507).

3. The display device as claimed in claim 1 or 2, wherein a channel length of one dummy thin-film transistor (401-404; 501-507; 601-609) is less than that of one of the switching thin-film transistors.

4. The display device as claimed in any of the preceding claims, further comprising:
a gate driver (32) operative to supply a plurality of scan signals (S1-Sn) to the display panel; and
a source driver (34) operative to supply a plurality of data signals (D1-Dm) to the display panel.

5. The display device as claimed in any of the preceding claims, further comprising:
means for providing signals to the display panel.

6. A display device for displaying images comprising:
a display panel (36) comprising:
a display area (362) comprising a plurality of display pixels (D11, D12) arranged in a matrix between gate lines (41) and source lines (40), each display pixel comprising at least one switching thin film transistor; and
a non-display pixel area (364) around the display area comprising non-display pixels (N11, N12);
each comprising a plurality of dummy thin-film transistors (401-404; 501-507; 601-609), wherein a number of the dummy thin-film transistors of each non-display pixel exceeds a number of the switching thin-film transistors of a first display pixel (D11) among the display pixels;
**characterized in that** the dummy thin-film transistors of each non-display pixel (N11) are divided into a first group of a plurality of first dummy thin-film transistors (601-603) connected in series between a source line and a capacitor (610) and a second group of a plurality of second dummy thin-film transistors (604-606) connected to each other in parallel between floating nodes, wherein all gates of the first group (601-603) and second group of dummy thin-film transistors (604-607) are connected to gate lines (61).

7. The display device as claimed in claim 6, wherein the second group of second dummy thin-film transistors comprises a plurality of groups of second dummy thin-film transistors connected to each other in parallel between floating nodes (604-606, 607-609).

8. The display device as claimed in claim 6 or 7, wherein the display device comprises an electronic device (3), the electronic device comprising the display panel (36).

9. The display device as claimed in claim 8, wherein the electronic device is a laptop computer, a cellular phone, a personal digital assistant, a notebook computer, a tablet computer, a car TV or a digital camera.

10. The display device as claimed in claim 8 or 9, further comprising:
means for providing signals to the display panel (36).

## Patentansprüche

1. Anzeigevorrichtung zum Anzeigen von Bildern, umfassend:
ein Anzeigefeld (36) umfassend:
einen Anzeigebereich (362), der eine Mehrzahl von Anzeigepixeln (D11, D12) aufweist, die in einer Matrix zwischen Gate-Leitungen (41) und Source-Leitungen (40) angeordnet sind, wobei jedes Anzeigepixel zumindest einen schaltenden Dünnschichttransistor aufweist; und
einen Nicht-Anzeigebereich (364), der um den Anzeigebereich (362) herum angeordnet ist und eine Mehrzahl von Nicht-Anzeigepixeln (N11, N12) aufweist;
die jeweils eine Mehrzahl von Dummy-Dünnschichttransistoren aufweist, wobei die Anzahl der Dummy-Dünnschichttransistoren (401-404; 501-507; 601-609) von jedem Nicht-Anzeigepixel (N11) die Anzahl der schaltenden Dünnschichttransistoren eines ersten Anzeigepixels (D11) unter den Anzeigepixeln übersteigt;
**dadurch gekennzeichnet, dass** die Dummy-Dünnschichttransistoren von jedem Nicht-Anzeigepixel (N11) in einer erste Gruppe bestehend aus einer Mehrzahl von ersten Dummy-Dünnschichttransistoren (401, 402), die in Reihe zwischen einer Source-Leitung und einem Kondensator (405) geschaltet sind, und eine zweite Gruppe bestehend aus seiner Mehrzahl von zweiten Dummy-Dünnschichttransistoren (403, 404) unterteilt sind, die miteinander zwischen Knotenpunkten ohne festes Bezugspotential in Reihe geschaltet sind,
wobei sämtliche Gates der ersten Gruppe (401, 402) und der zweiten Gruppe von Dummy-Dünnschichttransistoren (403, 404) mit den Gate-Leitungen (41, 51) verbunden sind.

2. Anzeigevorrichtung nach Anspruch 1, wobei die zweite Gruppe von zweiten Dummy-Dünnschichttransistoren eine Mehrzahl von Gruppen von zweiten Dummy-Dünnschichttransistoren umfasst, die miteinander zwischen Knotenpunkten (504-505, 506-507) ohne festes Bezugspotential in Reihe geschaltet sind.

3. Anzeigevorrichtung nach Anspruch 1 oder 2, wobei eine Kanallänge von einem der Dummy-Dünnschichttransistoren (401-404; 501-507; 601-609) geringer bzw. kürzer ist als diejenige von einem der schaltenden Dünnschichttransistoren.

4. Anzeigevorrichtung nach einem der vorhergehenden Ansprüche, weiterhin umfassend:
einen Gate-Treiber (32), der betrieblich ausgelegt ist, um dem Anzeigefeld eine Mehrzahl von Scansignalen (S1-Sn) bereitzustellen; und
einen Source-Treiber (34), der betrieblich ausgelegt ist, um dem Anzeigefeld eine Mehrzahl vonDatensignalen (D1-Dm) bereitzustellen.

5. Anzeigevorrichtung nach einem der vorhergehenden Ansprüche, weiterhin umfassend:
Mittel, um dem Anzeigefeld Signale zur Verfügung zu stellen.

6. Anzeigevorrichtung zum Anzeigen von Bildern, umfassend:
ein Anzeigefeld (36) umfassend:
einen Anzeigebereich (362), der eine Mehrzahl von Anzeigepixeln (D11, D12) aufweist, die in einer Matrix zwischen Gate-Leitungen (41) und Source-Leitungen (40) angeordnet sind, wobei jedes Anzeigepixel zumindest einen schaltenden Dünnschichttransistor aufweist; und
einen Nicht-Anzeigebereich (364), der um den Anzeigebereich herum angeordnet ist und eine Mehrzahl von Nicht-Anzeigepixeln (N11, N12) aufweist;
die jeweils eine Mehrzahl von Dummy-Dünnschichttransistoren (401-404; 501-507; 601-609) aufweist, wobei die Anzahl der Dummy-Dünnschichttransistoren von jedem Nicht-Anzeigepixel die Anzahl der schaltenden Dünnschichttransistoren eines ersten Anzeigepixels (D11) unter den Anzeigepixeln übersteigt;
**dadurch gekennzeichnet, dass** die Dummy-Dünnschichttransistoren von jedem Nicht-Anzeigepixel (N11) in einer erste Gruppe bestehend aus einer Mehrzahl von ersten Dummy-Dünnschichttransistoren (601-603), die in Reihe zwischen einer Source-Leitung und einem Kondensator (610) geschaltet sind, und eine zweite Gruppe bestehend aus seiner Mehrzahl von zweiten Dummy-Dünnschichttransistoren (604-606) unterteilt sind, die miteinander zwischen Knotenpunkten ohne festes Bezugspotential parallel geschaltet sind, wobei sämtliche Gates der ersten Gruppe (601-603) und der zweiten Gruppe von Dummy-Dünnschichttransistoren (604-607) mit Gate-Leitungen (61) verbunden sind.

7. Anzeigevorrichtung nach Anspruch 6, wobei die zweite Gruppe von zweiten Dummy-Dünnschichttransistoren eine Mehrzahl von Gruppen von zweiten Dummy-Dünnschichttransistoren umfasst, die miteinander parallel zwischen Knotenpunkten (604-606, 607-609) ohne festes Bezugspotential geschaltet sind.

8. Anzeigevorrichtung nach Anspruch 6 oder 7, wobei die Anzeigevorrichtung eine elektronische Einrichtung (3) aufweist, wobei die elektronische Einrichtung das Anzeigefeld (36) umfasst.

9. Anzeigevorrichtung nach Anspruch 8, wobei die elektronische Einrichtung ein Laptop-Computer, ein Mobiltelefon bzw. Handy, ein persönlicher digitaler Assistent, ein Notebook-Computer, ein Tablet-Computer, ein Auto-Fernsehgerät oder eine Digitalkamera ist.

10. Anzeigevorrichtung nach Anspruch 8 oder 9, weiterhin umfassend:
Mittel, um dem Anzeigefeld (36) Signale zur Verfügung zu stellen.

## Revendications

1. Un dispositif d'affichage pour l'affichage d'images comprenant :
un panneau d'affichage (36) comprenant :
une surface d'affichage (362) comprenant une pluralité de pixels d'affichage (D11, D12) disposés suivant une matrice entre des conducteurs de grille (41) et des conducteurs de source (40), chaque pixel d'affichage comprenant au moins un transistor de commutation à film mince ; et
une surface de non-affichage (364) autour de la surface d'affichage (362) comprenant une pluralité de pixels de non affichage (N11, N12) ;
chacun comprenant une pluralité de transistors fantômes à film mince, dans lequel un nombre de transistors fantômes à film mince (401-404 ; 501-507 ; 601-609) de chaque pixel de non-affichage (N11) excède le nombre de transistors de commutation à film mince d'un premier pixel d'affichage (D11) parmi les pixels d'affichage ;
**caractérisé en ce que** les transistors fantômes à film mince de chacun des pixels de non-affichage (N11) sont répartis entre un premier groupe d'une pluralité de premiers transistors fantômes à film mince (401, 402) connectés en série entre un conducteur de source et une capacité (405) et un second groupe d'une pluralité de seconds transistors fantômes à film mince (403, 405) connectés les uns aux autres en série entre des noeuds flottants ;
dans lequel toutes les grilles du premier groupe (401, 402) et du second groupe de transistors fantômes à film mince (403, 404) sont connectées aux conducteurs de grille (41, 51).

2. Le dispositif d'affichage tel que revendiqué dans la revendication 1, dans lequel le second groupe de seconds transistors fantômes à film mince comporte une pluralité de groupes de seconds transistors fantômes à film mince connectés les uns aux autres en série entre les noeuds flottants (504-505, 506-507).

3. Le dispositif d'affichage tel que revendiqué dans la revendication 1 ou 2, dans lequel une longueur de canal d'un transistor fantôme à film-mince (401-404 ; 501-507 ; 601-609) est inférieure à celle d'un transistor de commutation à film-mince.

4. Le dispositif d'affichage tel que revendiqué dans l'une quelconque des revendications précédentes, comprenant en outre :
- un pilote de grille (32) fonctionnant pour fournir une pluralité de signaux de balayage (S1-Sn) au panneau d'affichage ; et
- un pilote de source (24) fonctionnant pour fournir une pluralité de signaux de données (D1-Dm) au panneau d'affichage.

5. Le dispositif d'affichage tel que revendiqué dans l'une quelconque des revendications précédentes, comprenant en outre des moyens de générations de signaux au panneau d'affichage.

6. Un dispositif d'affichage pour l'affichage d'images comprenant :
un panneau d'affichage (36) comprenant :
une surface d'affichage (362) comprenant une pluralité de pixels d'affichage (D11, D12) disposés suivant une matrice entre des conducteurs de grille (41) et des conducteurs de source (40), chaque pixel d'affichage comprenant au moins un transistor de commutation à film mince ; et
une surface de pixels de non-affichage (364) autour de la surface d'affichage (362) comprenant des pixels de non affichage (N11, N12);
chacun comprenant une pluralité de transistors fantômes à film mince (401-404 ; 501-507 ; 601-609) dans lequel un nombre de transistors fantômes à film mince de chaque pixel de non-affichage (N11) excède un nombre de transistors de commutation à film mince d'un premier pixel d'affichage (D11) parmi les pixels d'affichage ;
**caractérisé en ce que** les transistors fantômes à film mince de chacun des pixels de non-affichage (N11) sont répartis entre un premier groupe d'une pluralité de premiers transistors fantômes à film mince (601-603) connectés en série entre un conducteur de source et une capacité (610) et un second groupe d'une pluralité de seconds transistors fantômes à film mince (604-606) connectés les uns aux autres en parallèle entre des noeuds flottants ;
dans lequel toutes les grilles du premier groupe (601, 603) et du second groupe de transistors fantômes à film mince (604, 607) sont connectées aux conducteurs de grille (41, 51).

7. Le dispositif d'affichage tel que revendiqué dans la revendication 6, dans lequel le second groupe de seconds transistors fantômes à film mince comporte une pluralité de groupes de seconds transistors fantômes à film mince connectés les uns aux autres en parallèle entre les noeuds flottants (604-606, 607-609).

8. Le dispositif d'affichage tel que revendiqué dans la revendication 6 ou 7, dans lequel le dispositif d'affichage comporte un dispositif électronique (3), le dispositif électronique comprenant un panneau d'affichage (36).

9. Le dispositif d'affichage tel que revendiqué dans la revendication 8, dans lequel le dispositif électronique est un ordinateur portable, un téléphone cellulaire, un assistant numérique personnel, un ordinateur ultra-portable, une tablette numérique, une télévision pour automobile ou un appareil photo numérique.

10. Le dispositif d'affichage tel que revendiqué dans la revendication 8 ou 9, comprenant en outre des moyens pour fournir des signaux au panneau d'affichage (36).
